# EUROPEAN PATENT SPECIFICATION

(11) **EP 4 496 222 B1**
(45) Date of publication and mention of the grant of the patent: **31.12.2025**
(21) Application number: 24181906.9
(22) Date of filing: 13.06.2024
(51) Int. Cl.: H03K 17/082, G06F 1/26, H03K 17/693

(54) **HIGH-VOLTAGE SWITCH CIRCUIT AND CORRESPONDING METHOD OF OPERATION**
HOCHSPANNUNGSSCHALTKREIS UND ENTSPRECHENDES BETRIEBSVERFAHREN
CIRCUIT DE COMMUTATION HAUTE TENSION ET PROCÉDÉ DE FONCTIONNEMENT CORRESPONDANT

(30) Priority: 21.07.2023 IT 202300015405
(43) Date of publication of application: 22.01.2025
(73) Proprietor: STMicroelectronics International N.V., 1228 Plan-les-Ouates, Geneva (CH)
(72) Inventor: PERRONI, Maurizio Francesco, 98054 Furnari (Messina) (IT); MANFRE', Davide, 26025 Pandino (Cremona) (IT); CARUSO, Massimo, 98122 Messina (IT); TORTI, Cesare, 27100 Pavia (IT); DISEGNI, Fabio Enrico Carlo, 26016 Spino d'Adda (Cremona) (IT)
(74) Representative: Buzzi, Notaro & Antonielli d'Oulx S.p.A.

(56) References cited:
- US-A1- 2011 148 368
- US-A1- 2016 315 539

## Description

### Technical field

The description relates to high-voltage switch circuits and corresponding methods of operation.

High-voltage switches may be applied to nonvolatile memories (NVM) where the state of a memory cell can be changed applying a programming current to the cell itself, such as phase-change memories (PCM), spin-torque magnetoresistive random-access memories (ST-MRAM), and resistive random-access memories (RRAM).

### Technological background

Document US 9219482 B2 discloses a high-voltage switch used to transfer a high voltage in a memory device. The architecture includes a single, high-voltage NMOS transistor that controls transmission of the high-voltage signal from an input terminal to an output terminal based on the voltage at the gate terminal of the NMOS transistor. The gate terminal of the NMOS transistor is driven using further high-voltage transistors that may be implemented with a triple well structure.

Another document possibly of interest is US 7385377 B2, which discloses a voltage-down converter used to step down an external supply voltage (e.g., 3 V) to a lower value (e.g., 1.85 V) for a memory device that operates at such lower voltage. The transconductance between the input node and the output node of the converter can be modulated by activating one or more drivers interposed therebetween. Each driver has two transistors arranged in series between the input node and the output node. The first one is a high-voltage transistor that is configured to withstand the high power supply voltage, while the second one is a low-voltage transistor that is configured to switch on and off the driver in a relatively short time.

Other documents possibly of interest in the field of the invention include US 10714183 B2, US 2023/0015995 A1, US 2022/0321116 A1, US 2021/0408891 A1, US 2016/0315539 A1 and US 2011/0148368 A1.

In some memory applications, high-voltage switches may be used to toggle the voltages that are used during a memory modify operation (e.g., write operation or programming operation), e.g., to switch the column supply voltage between 2 V and 4.8 V. Thus, since the voltage domain of the circuits may be between ground voltage (e.g., 0 V) and a relatively high voltage (e.g., 4.8 V or 5 V), the high-voltage switch circuits are conventionally designed (e.g., sized) for such a voltage rating. Such sizing implies thick gate oxide and/or large area occupation, and the fabrication of such high-voltage transistors also requires dedicated manufacturing steps and dedicated masks that make the manufacturing costs increase.

Therefore, there is a need in the art to provide improved high-voltage switch circuits that do not rely on high-voltage rating transistors.

### Object and summary

An object of one or more embodiments is to contribute in providing such improved high-voltage switch circuits that can handle high voltages (e.g., in the range of 0 V to about 5 V) without implementing high-voltage rating transistors, but implementing (only) low-voltage rating transistors (e.g., in the range of 0 V to about 2.5 V).

According to one or more embodiments, such an object can be achieved by a switch circuit having the features set forth in the claims that follow.

One or more embodiments may relate to a corresponding method of operation.

The claims are an integral part of the technical teaching provided herein in respect of the embodiments.

According to an aspect of the present description, in a switch circuit a first input node is configured to receive a first input voltage, a second input node is configured to receive a second input voltage lower than the first input voltage, and an output node is configured to produce an output voltage switchable between the first input voltage and the second input voltage. A first pass device and a second pass device are arranged in series between the first input node and the output node. A third pass device and a fourth pass device are arranged in series between the second input node and the output node. A first elevator circuit is configured to receive a first low-voltage control signal and produce a corresponding first shifted control signal to control the first pass device. The first elevator circuit is biased between the first input voltage and a shifted ground voltage. A second elevator circuit is configured to receive a second low-voltage control signal and produce a corresponding second shifted control signal to control the second pass device. The second elevator circuit is biased between the output voltage and an elevated ground voltage. A third elevator circuit is configured to receive a third low-voltage control signal and produce a corresponding third shifted control signal to control the third pass device. The third elevator circuit is biased between the second input voltage and a ground voltage. A fourth elevator circuit is configured to receive a fourth low-voltage control signal and produce a corresponding fourth shifted control signal to control the fourth pass device. The fourth elevator circuit is biased between the output voltage and the elevated ground voltage.

One or more embodiments may thus provide a switch circuit able to manage high voltages (e.g., in the range of 0 V to 5 V) without resorting to high-voltage rating devices but using (only) low-voltage rating devices (e.g., in the range of 0 V to 2.5 V).

According to another aspect of the present description, a method of operating a switch circuit includes:
- receiving a first input voltage at a first input node;
- receiving a second input voltage lower than the first input voltage at a second input node;
- switching an output node between the first input voltage and the second input voltage to produce the output voltage;
- receiving a first low-voltage control signal at a first elevator circuit and producing a corresponding first shifted control signal;
- biasing the first elevator circuit between the first input voltage and a shifted ground voltage;
- receiving a second low-voltage control signal at a second elevator circuit and producing a corresponding second shifted control signal;
- biasing the second elevator circuit between the output voltage and an elevated ground voltage;
- receiving a third low-voltage control signal at a third elevator circuit and producing a corresponding third shifted control signal;
- biasing the third elevator circuit between the second input voltage and a ground voltage;
- receiving a fourth low-voltage control signal at a fourth elevator circuit and producing a corresponding fourth shifted control signal; and
- biasing the fourth elevator circuit between the output voltage and the elevated ground voltage.

### Brief description of the drawings

One or more embodiments will now be described, by way of example, with reference to the annexed figures, wherein:
- Figure 1 is a circuit block diagram exemplary of a high-voltage switch circuit;
- Figure 2 is a circuit block diagram exemplary of an elevator circuit for use in the switch circuit of Figure 1;
- Figure 3 is a circuit block diagram exemplary of a high-voltage switch circuit according to one or more embodiments of the present description;
- Figure 4 is a circuit block diagram exemplary of an elevator circuit according to one or more embodiments of the present description, e.g., for use in the switch circuit of Figure 3; and
- Figure 5 is a circuit block diagram exemplary of another elevator circuit according to one or more embodiments of the present description, e.g., for use in the switch circuit of Figure 3.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is included in at least one embodiment. Hence, phrases such as "in an embodiment" or "in one embodiment" that may be present in one or more points of the present description do not necessarily refer to one and the same embodiment. Moreover, particular configurations, structures, or characteristics may be combined in any adequate way in one or more embodiments.

The headings/references used herein are provided merely for convenience and hence do not define the extent of protection or the scope of the embodiments.

Throughout the figures annexed herein, unless the context indicates otherwise, like parts or elements are indicated with like references/numerals and a corresponding description will not be repeated for the sake of brevity.

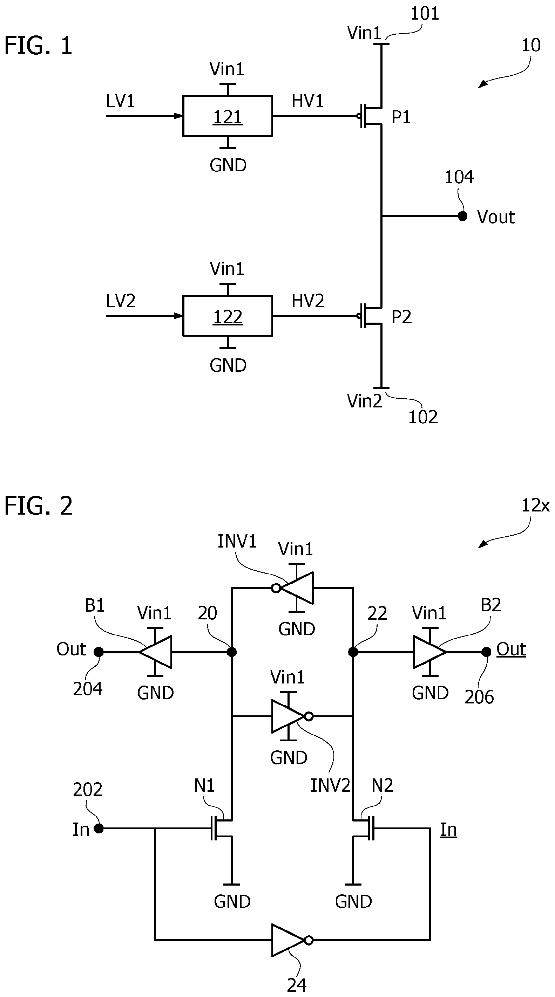

By way of introduction to the detailed description of exemplary embodiments, reference may be made to Figures 1 and 2, discussed in the following.

Figure 1 is a circuit block diagram exemplary of a high-voltage switch circuit 10. As exemplified in Figure 1, a high-voltage switch is a circuit that produces an output voltage Vout that can switch between two values, a high value Vin1 (e.g., 5 V) and a low value Vin2 (e.g., 2 V), depending on the value of one or more low-voltage input control signals LV1, LV2 (e.g., with LV1 and LV2 in the voltage range of 0 V to about Vin2). As exemplified in Figure 1, a high-voltage switch 10 includes a first control terminal configured to receive a first low-voltage control signal LV1, a second control terminal configured to receive a second low-voltage control signal LV2, a first voltage input terminal 101 configured to receive a first input voltage Vin1, a second voltage input terminal 102 configured to receive a second input voltage Vin2, and an output terminal 104 configured to produce the output voltage Vout. A first pass device P1 (or pass element, e.g., a transistor, particularly a p-channel MOS transistor) is arranged between the first voltage input terminal 101 and the output terminal 104, and a second pass device P2 (e.g., a transistor, particularly a p-channel MOS transistor) is arranged between the second voltage input terminal 102 and the output terminal 104. A first elevator circuit 121 biased between Vin1 and ground GND is configured to receive the control signal LV1 and to shift (elevate) it to a higher voltage domain (e.g., in the range of 0 V to Vin1) to produce a first high-voltage control signal HV1 that controls the first pass device P1 (e.g., is received at the gate terminal of MOS transistor P1). A second elevator circuit 122 biased between Vin1 and ground GND is configured to receive the control signal LV2 and to shift (elevate) it to a higher voltage domain (e.g., in the range of 0 V to Vin1) to produce a second high-voltage control signal HV2 that controls the second pass device P2 (e.g., is received at the gate terminal of MOS transistor P2).

Each of the elevator circuits 121 and 122 (also collectively or individually referred to as elevator circuits 12x) may have the architecture exemplified in the circuit block diagram of Figure 2. An elevator circuit 12x includes an input terminal 202 configured to receive a low-voltage input signal In (e.g., LV1 or LV2 with reference to Figure 1) and an output terminal 204 configured to produce a high-voltage output signal Out (e.g., HV1 or HV2 with reference to Figure 1). The elevator circuit 12x includes a latch including two inverters INV1 and INV2. Both inverters INV1 and INV2 are biased between Vin1 and ground GND. The output terminal of inverter INV1 is connected to the input terminal of inverter INV2 at a node 20 and the output terminal of inverter INV2 is connected to the input terminal of inverter INV1 at a node 22. A transistor N1 (e.g., an n-channel MOS transistor) has a conductive channel arranged between node 20 and ground GND, and is configured to receive signal In as a control signal. For instance, transistor N1 has a drain terminal coupled to node 20, a source terminal coupled to ground GND, and a gate terminal coupled to the input terminal 202 of the elevator circuit 12x. A transistor N2 (e.g., an n-channel MOS transistor) has a conductive channel arranged between node 22 and ground GND, and is configured to receive the complement In of signal In as a control signal. For instance, transistor N2 has a drain terminal coupled to node 22, a source terminal coupled to ground GND, and a gate terminal coupled to the output of a further inverter circuit 24 that has its input coupled to the input terminal 202 of the elevator circuit 12x. Additionally, a first buffer circuit B1 biased between Vin1 and ground GND has an input terminal connected to node 20 and an output terminal connected to the output terminal 204 of the elevator circuit 12x to produce the high-voltage output signal Out. Optionally, a second buffer circuit B2 biased between Vin1 and ground GND has an input terminal connected to node 22 and an output terminal connected to a further output terminal 206 of the elevator circuit 12x to produce the complement Out of the high-voltage output signal Out.

High-voltage switches as exemplified in Figure 1, implementing elevator circuits as exemplified in Figure 2, may be used to toggle the "high" voltages that are used during a memory modify operation (e.g., write operation or programming operation), e.g., to switch the column supply voltage between 2 V and 4.8 V. Since the voltage domain of the elevator circuits 121, 122 and of the pass devices P1, P2 may be between ground voltage (e.g., 0 V) and Vin1 (e.g., 5 V), the elevator circuits and the pass devices may be designed (e.g., sized) for such a voltage rating. Such sizing may imply thick gate oxide and/or large area occupation, and the fabrication of such high-voltage transistors may also require dedicated manufacturing steps and dedicated masks that make the manufacturing costs increase.

Therefore, one or more embodiments relate to an improved high-voltage switch circuit that does not rely on high-voltage rating transistors.

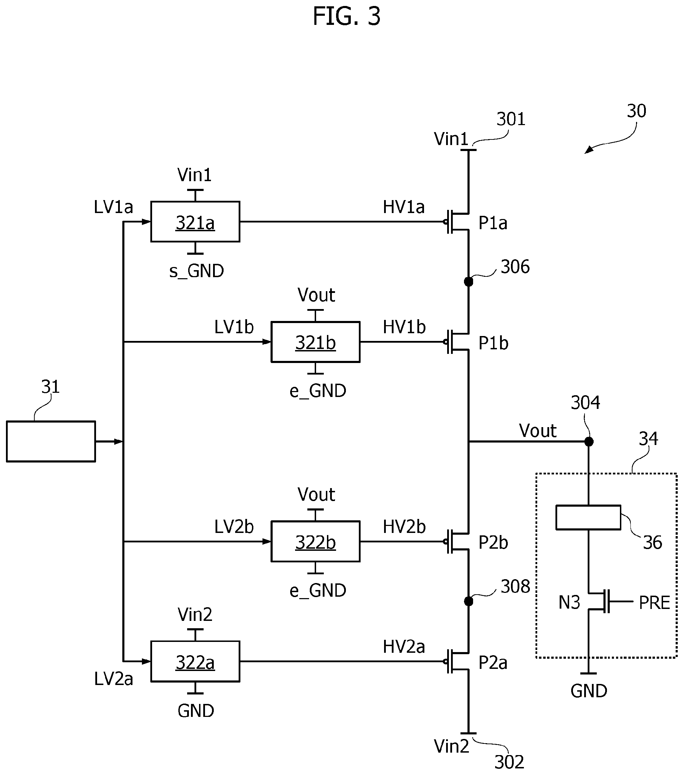

In detail, Figure 3 is a circuit block diagram exemplary of a high-voltage switch circuit 30 according to one or more embodiments. As exemplified in Figure 3, switch 30 includes a first control terminal configured to receive a first low-voltage control signal LV1a, a second control terminal configured to receive a second low-voltage control signal LV1b, a third control terminal configured to receive a third low-voltage control signal LV2a, and a fourth control terminal configured to receive a fourth low-voltage control signal LV2b. The low-voltage control signals LV1a, LV1b, LV2a and LV2b may be produced by a control circuit 31 (e.g., a memory control circuit).

As exemplified in Figure 3, the switch 30 further includes a first voltage input terminal 301 configured to receive a first input voltage Vin1 (e.g., about 5 V), a second voltage input terminal 302 configured to receive a second input voltage Vin2 (e.g., about 2 V), and an output terminal 304 configured to produce the output voltage Vout. A first pass device P1a and a second pass device P1b (or pass elements, e.g., transistors, particularly p-channel MOS transistors) are arranged in series between the first voltage input terminal 301 and the output terminal 304. For instance, transistor P1a has a source terminal coupled to node 301 and a drain terminal coupled to a node 306, and transistor P1b has a source terminal coupled to node 306 and a drain terminal coupled to the output node 304. A third pass device P2a and a fourth pass device P2b (or pass elements, e.g., transistors, particularly p-channel MOS transistors) are arranged in series between the second voltage input terminal 302 and the output terminal 304. For instance, transistor P2a has a drain terminal coupled to node 302 and a source terminal coupled to a node 308, and transistor P2b has a drain terminal coupled to node 308 and a source terminal coupled to the output node 304.

As exemplified in Figure 3, switch 30 includes a first elevator circuit 321a biased between Vin1 and a shifted ground voltage s_GND. The shifted ground voltage s_GND is a fixed voltage higher than ground (i.e., higher than 0 V) and chosen so that the first elevator circuit 321a is subject to a low-voltage domain (e.g., of about 2 V or 2.5 V). For instance, the shifted ground voltage s_GND may be equal to half of voltage Vin1 (e.g., s_GND = Vin1/2 = 5 V/2 = 2.5 V) or may be equal to voltage Vin1 lowered by a certain amount Vx (e.g., s_GND = Vin1-Vx = 5 V-2 V = 3 V). The first elevator circuit 321a is configured to receive the first control signal LV1a and to shift (elevate) it to the voltage domain between Vin1 and s_GND to produce a first shifted control signal HV1a that controls the first pass device P1a (e.g., is received at the gate terminal of MOS transistor P1a).

As exemplified in Figure 3, switch 30 includes a second elevator circuit 321b biased between Vout and an elevated ground voltage e_GND. The elevated ground voltage e_GND is a variable voltage chosen, as a function of the current value of the output voltage Vout (or, more particularly, as a function of the commutation state of the output voltage Vout), so that the second elevator circuit 321b is subject to a low-voltage domain (e.g., of about 2 V or 2.5 V). For instance, the elevated ground voltage e_GND may be equal to ground voltage GND (e.g., 0 V) when the output voltage Vout is low (e.g., equal to Vin2), and may be equal to the shifted ground voltage s_GND when the output voltage Vout is high (e.g., equal to Vin1). The second elevator circuit 321b is configured to receive the second control signal LV1b and to shift (elevate) it to the voltage domain between Vout and e_GND to produce a second shifted control signal HV1b that controls the second pass device P1b (e.g., is received at the gate terminal of MOS transistor P1b).

As exemplified in Figure 3, switch 30 includes a third elevator circuit 322a biased between Vin2 and ground GND, so that the third elevator circuit 322a is subject to a low-voltage domain (e.g., of about 2 V or 2.5 V). The third elevator circuit 322a is configured to receive the third control signal LV2a and to shift (elevate) it to the voltage domain between Vin2 and GND to produce a third shifted control signal HV2a that controls the third pass device P2a (e.g., is received at the gate terminal of MOS transistor P2a).

As exemplified in Figure 3, switch 30 includes a fourth elevator circuit 322b biased between Vout and the elevated ground voltage e_GND. The fourth elevator circuit 322b is configured to receive the fourth control signal LV2b and to shift (elevate) it to the voltage domain between Vout and e_GND to produce a fourth shifted control signal HV2b that controls the fourth pass device P2b (e.g., is received at the gate terminal of MOS transistor P2b).

As exemplified in Figure 3, a precharge circuit 34 may be coupled between the switch output node 304 and ground GND. The precharge circuit 34 may include a pull-down pass device N3 (or pass element, e.g., a transistor, particularly an n-channel MOS transistor) controlled by a precharge signal PRE. The precharge signal PRE may be provided, for instance, by the control circuit 31. Optionally, a cascode circuit 36 is connected in series to the pass device N3. For instance, the cascode circuit 36 has a first terminal coupled to node 304 and a second terminal coupled to a drain terminal of the MOS transistor N3. The MOS transistor N3 has a source terminal coupled to ground GND and a gate terminal configured to receive signal PRE. The cascode circuit 36 may include, for instance, one or more diode-connected transistors connected in series, and/or one or more diodes connected in series.

Resorting to the architecture of Figure 3, the high-voltage switch 30 allows driving the output node 304 to voltage Vin1 or Vin2 while keeping all the electrical components (e.g., the elevator circuits and the pass devices) in a low voltage range (e.g., a voltage range of about 2 V or 2.5 V). In particular, elevator circuits 321a and 322a are biased by fixed voltages whose difference (e.g., Vin1-s_GND for elevator circuit 321a and Vin2-GND for elevator circuit 322a) is in the range of about 2 V or 2.5 V, while elevator circuits 321b and 322b are biased by variable voltages whose difference (e.g., Vout-e_GND for both elevator circuits 321b and 322b) is kept in the range of about 2 V or 2.5 V. By doing so, transistors P1a, P1b, P2a, P2b as well as the transistors within the elevator circuits 321a, 321b, 322a, 322b do not need to be sized for high-voltage rating, and thus can be manufactured with thinner gate oxide, occupying less silicon area and/or using less photolithographic masks.

In particular, the control circuit 31 may produce the control signals (e.g., LV1a, LV1b, LV2a, LV2b as well as PRE) so that the commutation of voltage Vout from the high value Vin1 to the low value Vin2 is carried out in three steps. Initially, transistors P1a and P1b are conductive (on) and transistors P2a and P2b are non-conductive (off). In the first commutation step, transistors P1a and P1b are turned into a non-conductive state (off) and the precharge circuit 34 is activated (e.g., asserting signal PRE) to discharge node 304 and lower the output voltage Vout from Vin1 (e.g., 5 V) to a lower value (e.g., about half of Vin2, such as 2.4 V). In the second commutation step, the elevated ground voltage e_GND is adjusted so as to provide the correct voltage bias to elevator circuits 321b and 322b, e.g., voltage e_GND is set to ground voltage GND. In the third commutation step, the precharge circuit 34 is deactivated (e.g., de-asserting signal PRE) and transistors P2a and P2b are turned into a conductive state (on) so that the output voltage Vout is driven to the desired value Vin2.

Similarly, the control circuit 31 may produce the control signals (e.g., LV1a, LV1b, LV2a, LV2b as well as PRE) so that the commutation of voltage Vout from the low value Vin2 to the high value Vin1 is carried out in three steps. Initially, transistors P2a and P2b are conductive (on) and transistors P1a and P1b are non-conductive (off). In the first commutation step, transistors P2a and P2b are turned into a non-conductive state (off). In the second commutation step, the elevated ground voltage e_GND is adjusted so as to provide the correct voltage bias to elevator circuits 321b and 322b, e.g., voltage e_GND is set to the shifted ground voltage s_GND. In this step, the value of signal HV1b driving transistor P1b remains compatible with the switching-on of transistor P1b and allows the output voltage Vout to subsequently reach the desired value Vin1. In the third commutation step, transistors P1a and P1b are turned into a conductive state (on) so that the output voltage Vout is driven to the desired value Vin1.

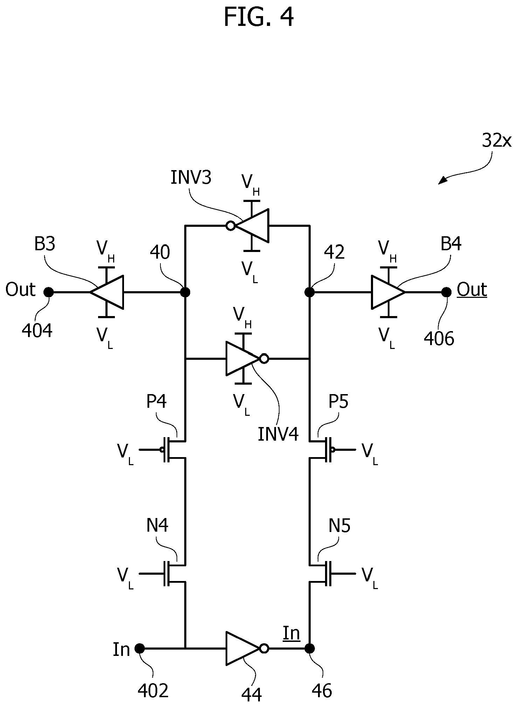

Each of the elevator circuits 321a, 321b, 322a, 322b (also collectively or individually referred to as elevator circuits 32x) may have the architecture exemplified in the circuit block diagram of Figure 4. An elevator circuit 32x includes an input terminal 402 configured to receive a low-voltage input signal In (e.g., LV1a, LV1b, LV2a or LV2b with reference to Figure 3) and an output terminal 404 configured to produce a high-voltage output signal Out (e.g., HV1a, HV1b, HV2a or HV2b with reference to Figure 3) . The elevator circuit 32x includes a latch including two inverters INV3 and INV4. Both inverters INV3 and INV4 are biased between a higher voltage V_{H} and a lower voltage V_{L}. The values of voltages V_{H} and V_{L} are chosen so that the elevator circuit 32x is subject to a low-voltage domain (e.g., of about 2 V or 2.5 V). For instance, in the case of elevator circuit 321a, V_{H} may be equal to Vin1 and V_{L} may be equal to s_GND; in the case of elevator circuits 321b and 322b, V_{H} may be equal to Vout and V_{L} may be equal to e_GND; in the case of elevator circuit 322a, V_{H} may be equal to Vin2 and V_{L} may be equal to GND. The output terminal of inverter INV3 is connected to the input terminal of inverter INV4 at a node 40 and the output terminal of inverter INV4 is connected to the input terminal of inverter INV3 at a node 42. The voltage swing of the input signal In is between ground GND and V_{L}.

As exemplified in Figure 4, a transistor N4 (e.g., an n-channel MOS transistor) has a conductive channel arranged between node 40 and the input terminal 402. Optionally, another transistor P4 (e.g., a p-channel MOS transistor) has a conductive channel arranged between node 40 and the input terminal 402, in series to transistor N4. In particular, transistor N4 has a source terminal coupled to node 402 to receive the input signal In, a drain terminal coupled to the drain terminal of transistor P4, and a gate terminal configured to receive the lower bias voltage V_{L} (e.g., 2.5 V). Transistor P4 has a drain terminal coupled the drain terminal of transistor N4, a source terminal coupled to node 40, and a gate terminal configured to receive the lower bias voltage V_{L}.

As exemplified in Figure 4, a transistor N5 (e.g., an n-channel MOS transistor) has a conductive channel arranged between node 42 and a node 46 where the complement signal In of the input signal In is produced by a further inverter 44 having its input terminal coupled to node 402. Optionally, another transistor P5 (e.g., a p-channel MOS transistor) has a conductive channel arranged between node 42 and node 46, in series to transistor N5. In particular, transistor N5 has a source terminal coupled to node 46 to receive signal In, a drain terminal coupled to the drain terminal of transistor P5, and a gate terminal configured to receive the lower bias voltage V_{L}. Transistor P5 has a drain terminal coupled the drain terminal of transistor N5, a source terminal coupled to node 42, and a gate terminal configured to receive the lower bias voltage V_{L}.

Additionally, a first buffer circuit B3 biased between voltage V_{H} and voltage V_{L} has an input terminal connected to node 40 and an output terminal connected to the output terminal 404 of the elevator circuit 32x to produce the high-voltage output signal Out. Optionally, a second buffer circuit B4 biased between voltage V_{H} and voltage V_{L} has an input terminal connected to node 42 and an output terminal connected to a further output terminal 406 of the elevator circuit 32x to produce the complement Out of the high-voltage output signal Out.

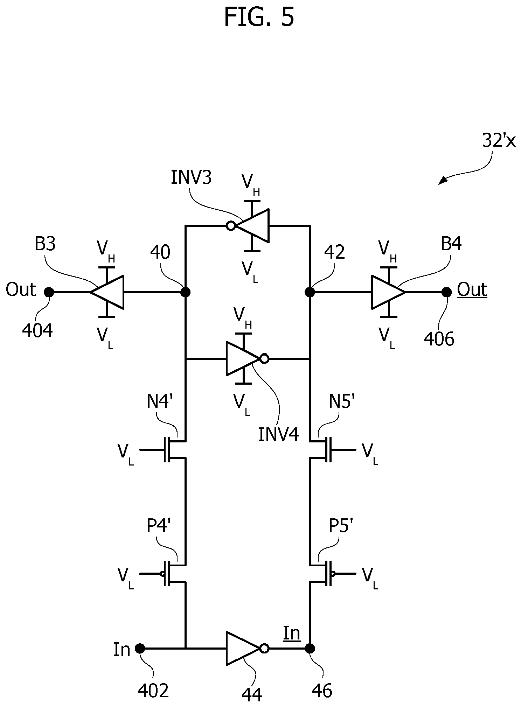

As exemplified in Figure 5, modifying the architecture of Figure 4 provides an elevator circuit 32'x that can be used for negative voltages. Substantially, the elevator circuit 32'x of Figure 5 is the same as in Figure 4, with p-channel MOS transistors P4' and P5' in the place of the n-channel MOS transistors N4 and N5, as well as n-channel MOS transistors N4' and N5' in the place of the p-channel MOS transistors P4 and P5. The higher supply voltage V_{H} may be equal to ground voltage GND, and the lower supply voltage V_{L} may be a negative voltage. The voltage of the input signal In (and its complement In) may be in the range of 0 V to about 1 V.

Resorting to the architecture of Figure 4 for the elevator circuits 32x (i.e., by driving the elevator circuits from their source terminals instead from their gate terminals as in Figure 2), the electrical components are kept in a low voltage range (e.g., a voltage range of about 2 V or 2.5 V) and do not need to be sized for high-voltage rating.

As anticipated, high-voltage switch circuits as disclosed herein may be used in the control circuits of a memory, such as in the row decoder circuits.

One or more embodiments as exemplified herein may thus be advantageous insofar as they facilitate managing "high" voltages (e.g., in the range of 0 V to 5 V) without resorting to high-voltage rating devices but using (only) low-voltage rating devices (e.g., in the range of 0 V to 2.5 V). This reduces the thickness of the gate oxide, the area occupation, and reduces the number of manufacturing steps, thus reducing manufacturing costs (masks costs) without degrading the performance.

The extent of protection is determined by the annexed claims.

## Claims

1. A switch circuit (30), comprising:
a first input node (301) configured to receive a first input voltage (Vin1), a second input node (302) configured to receive a second input voltage (Vin2) lower than said first input voltage (Vin1), and an output node (304) configured to produce an output voltage (Vout) switchable between said first input voltage (Vin1) and said second input voltage (Vin2);
a first pass device (P1a) and a second pass device (P1b) arranged in series between said first input node (301) and said output node (304);
a third pass device (P2a) and a fourth pass device (P2b) arranged in series between said second input node (302) and said output node (304);
a first elevator circuit (321a) configured to receive a first low-voltage control signal (LV1a) and produce a corresponding first shifted control signal (HV1a) to control said first pass device (P1a), wherein the first elevator circuit (321a) is biased between said first input voltage (Vin1) and a shifted ground voltage (s_GND);
a second elevator circuit (321b) configured to receive a second low-voltage control signal (LV1b) and produce a corresponding second shifted control signal (HV1b) to control said second pass device (P1b), wherein the second elevator circuit (321b) is biased between said output voltage (Vout) and an elevated ground voltage (e_GND);
a third elevator circuit (322a) configured to receive a third low-voltage control signal (LV2a) and produce a corresponding third shifted control signal (HV2a) to control said third pass device (P2a), wherein the third elevator circuit (322a) is biased between said second input voltage (Vin2) and a ground voltage (GND);
a fourth elevator circuit (322b) configured to receive a fourth low-voltage control signal (LV2b) and produce a corresponding fourth shifted control signal (HV2b) to control said fourth pass device (P2b), wherein the fourth elevator circuit (322b) is biased between said output voltage (Vout) and said elevated ground voltage (e_GND).

2. The switch circuit (30) of claim 1, wherein said shifted ground voltage (s_GND) is a fixed voltage and a difference between said first input voltage (Vin1) and the shifted ground voltage (s_GND) is in the range of 2 V to 2.5 V.

3. The switch circuit (30) of claim 1 or claim 2, wherein said elevated ground voltage (s_GND) is a variable voltage switchable between said shifted ground voltage (s_GND) and said ground voltage (GND), and wherein said elevated ground voltage (s_GND) is switched to:
said shifted ground voltage (s_GND), in response to said output voltage (Vout) being switched to the first input voltage (Vin1); and
said ground voltage (GND), in response to said output voltage (Vout) being switched to the second input voltage (Vin2).

4. The switch circuit (30) of aby of the previous claims, comprising a precharge circuit (34) coupled between said output node (304) and ground (GND), the precharge circuit (34) being activatable (PRE) in response to said output voltage (Vout) being switched from the first input voltage (Vin1) to the second input voltage (Vin2).

5. The switch circuit (30) of claim 4, wherein said precharge circuit (34) comprises a pull-down device (N3) controllable by a precharge signal (PRE), and a cascode device (36) coupled in series to the pull-down device.

6. The switch circuit (30) of any of the previous claims, comprising a control circuit (31) configured to produce said first (LV1a), second (LV1b), third (LV2a) and fourth (LV2b) low-voltage control signals and said elevated ground voltage (e_GND),
wherein the control circuit (31) is configured to switch said output voltage (Vout) from said first input voltage (Vin1) to said second input voltage (Vin2) by sequentially performing the following steps (i) to (iii):
(i) turning off said first (P1a) and second (P1b) pass devices;
(ii) setting said elevated ground voltage (e_GND) to ground voltage (GND); and
(iii) turning on said third (P2a) and fourth (P2b) pass devices;
and wherein the control circuit (31) is configured to switch said output voltage (Vout) from said second input voltage (Vin2) to said first input voltage (Vin1) by sequentially performing the following steps (iv) to (vi):
(iv) turning off said third (P2a) and fourth (P2b) pass devices;
(v) setting said elevated ground voltage (e_GND) to said shifted ground voltage (s_GND); and
(vi) turning on said first (P1a) and second (P1b) pass devices.

7. The switch circuit (30) of claims 4 and 6, wherein the control circuit (31) is further configured to:
during step (i), activate (PRE) said precharge circuit (34) to lower said output voltage (Vout); and
during step (iii), deactivate (PRE) said precharge circuit (34).

8. The switch circuit (30) of any of the previous claims, wherein said first input voltage (Vin1) is in the range of 4.5 V to 5 V and said second input voltage (Vin2) is in the range of 2 V to 2.5 V.

9. The switch circuit (30) of any of the previous claims, wherein said first (P1a), second (P1b), third (P2a) and fourth (P2b) pass devices include respective p-channel MOS transistors.

10. The switch circuit (30) of any of the previous claims, wherein each of said first (321a), second (321b), third (322a) and fourth (322b) elevator circuits comprises:
a respective input node (402) configured to receive the respective low-voltage control signal (In) and a respective output node (404) configured to produce the respective shifted control signal (Out);
a latch circuit including a first latched inverter (INV3) and a second latched inverter (INV4), the first latched inverter (INV3) having an input terminal connected to a first latch node (42) and an output terminal connected to a second latch node (40), and the second latched inverter (INV4) having an input terminal connected to the second latch node (40) and an output terminal connected to the first latch node (42);
a further inverter (44) coupled between said respective input node (402) and a respective further node (46) and configured to produce, at said further node (46), the complement signal (In) of the respective low-voltage control signal (In);
a first transistor (N4) having a source terminal coupled to said respective input node (402) to receive the respective low-voltage control signal (In) and a drain terminal coupled (P4) to said second latch node (40); and
a second transistor (N5) having a source terminal coupled to said respective further node (46) to receive the complement signal (In) of the respective low-voltage control signal (In) and a drain terminal coupled (P5) to said first latch node (42);
wherein said second latch node (40) is coupled (B3) to said respective output node (404).

11. The switch circuit (30) of claim 10, wherein each of said first (321a), second (321b), third (322a) and fourth (322b) elevator circuits comprises:
a third transistor (P4) having a conductive channel arranged between the drain terminal of said first transistor (N4) and said second latch node (40); and
a fourth transistor (P5) having a conductive channel arranged between the drain terminal of said second transistor (N5) and said first latch node (42).

12. A method of operating a switch circuit (30) according to any of the previous claims, the method comprising:
receiving a first input voltage (Vin1) at said first input node (301);
receiving a second input voltage (Vin2) lower than said first input voltage (Vin1) at said second input node (302);
switching said output node (304) between said first input voltage (Vin1) and said second input voltage (Vin2) to produce said output voltage (Vout);
receiving a first low-voltage control signal (LV1a) at said first elevator circuit (321a) and producing a corresponding first shifted control signal (HV1a);
biasing said first elevator circuit (321a) between said first input voltage (Vin1) and a shifted ground voltage (s_GND);
receiving a second low-voltage control signal (LV1b) at said second elevator circuit (321b) and producing a corresponding second shifted control signal (HV1b);
biasing said second elevator circuit (321b) between said output voltage (Vout) and an elevated ground voltage (e_GND);
receiving a third low-voltage control signal (LV2a) at said third elevator circuit (322a) and producing a corresponding third shifted control signal (HV2a);
biasing said third elevator circuit (322a) between said second input voltage (Vin2) and a ground voltage (GND);
receiving a fourth low-voltage control signal (LV2b) at said fourth elevator circuit (322b) and producing a corresponding fourth shifted control signal (HV2b);
biasing said fourth elevator circuit (322b) between said output voltage (Vout) and said elevated ground voltage (e_GND).

## Patentansprüche

1. Schalterschaltung (30), umfassend:
einen ersten Eingangsknoten (301), der so konfiguriert ist, dass er eine erste Eingangsspannung (Vin1) empfängt, einen zweiten Eingangsknoten (302), der so konfiguriert ist, dass er eine zweite Eingangsspannung (Vin2) empfängt, die niedriger ist als die erste Eingangsspannung (Vin1), und einen Ausgangsknoten (304), der so konfiguriert ist, dass er eine zwischen der ersten Eingangsspannung (Vin1) und der zweiten Eingangsspannung (Vin2) umschaltbare Ausgangsspannung (Vout) erzeugt;
eine erste Durchgangsvorrichtung (P1a) und eine zweite Durchgangsvorrichtung (P1b), die in Reihe zwischen dem ersten Eingangsknoten (301) und dem Ausgangsknoten (304) angeordnet sind;
eine dritte Durchgangsvorrichtung (P2a) und eine vierte Durchgangsvorrichtung (P2b), die in Reihe zwischen dem zweiten Eingangsknoten (302) und dem Ausgangsknoten (304) angeordnet sind;
eine erste Erhöhungsschaltung (321a), die so konfiguriert ist, dass sie ein erstes Niederspannungssteuersignal (LV1a) empfängt und ein entsprechendes erstes verschobenes Steuersignal (HV1a) erzeugt, um die erste Durchgangsvorrichtung (P1a) zu steuern, wobei die erste Erhöhungsschaltung (321a) zwischen der ersten Eingangsspannung (Vin1) und einer verschobenen Massespannung (s_GND) vorgespannt ist;
eine zweite Erhöhungsschaltung (321b), die so konfiguriert ist, dass sie ein zweites Niederspannungssteuersignal (LV1b) empfängt und ein entsprechendes zweites verschobenes Steuersignal (HV1b) erzeugt, um die zweite Durchgangsvorrichtung (P1b) zu steuern, wobei die zweite Erhöhungsschaltung (321b) zwischen der Ausgangsspannung (Vout) und einer erhöhten Massespannung (e_GND) vorgespannt ist;
eine dritte Erhöhungsschaltung (322a), die so konfiguriert ist, dass sie ein drittes Niederspannungssteuersignal (LV2a) empfängt und ein entsprechendes drittes verschobenes Steuersignal (HV2a) erzeugt, um die dritte Durchgangsvorrichtung (P2a) zu steuern, wobei die dritte Erhöhungsschaltung (322a) zwischen der zweiten Eingangsspannung (Vin2) und einer Massespannung (GND) vorgespannt ist;
eine vierte Erhöhungsschaltung (322b), die so konfiguriert ist, dass sie ein viertes Niederspannungssteuersignal (LV2b) empfängt und ein entsprechendes viertes verschobenes Steuersignal (HV2b) erzeugt, um die vierte Durchgangsvorrichtung (P2b) zu steuern, wobei die vierte Erhöhungsschaltung (322b) zwischen der Ausgangsspannung (Vout) und der erhöhten Massespannung (e_GND) vorgespannt ist.

2. Schalterschaltung (30) nach Anspruch 1, wobei die verschobene Massespannung (s_GND) eine feste Spannung ist und die Differenz zwischen der ersten Eingangsspannung (Vin1) und der verschobenen Massespannung (s_GND) in dem Bereich von 2 V bis 2,5 V liegt.

3. Schalterschaltung (30) nach Anspruch 1 oder Anspruch 2, wobei die erhöhte Massespannung (s_GND) eine variable Spannung ist, die zwischen der verschobenen Massespannung (s_GND) und der Massespannung (GND) umschaltbar ist, und wobei die erhöhte Massespannung (s_GND) auf Folgendes umgeschaltet wird:
die verschobene Massespannung (s_GND), als Reaktion darauf, dass die Ausgangsspannung (Vout) auf die erste Eingangsspannung (Vin1) umgeschaltet wird; und
die Massespannung (GND), als Reaktion darauf, dass die Ausgangsspannung (Vout) auf die zweite Eingangsspannung (Vin2) umgeschaltet wird.

4. Schalterschaltung (30) nach einem der vorhergehenden Ansprüche, umfassend eine Vorladeschaltung (34), die zwischen dem Ausgangsknoten (304) und Masse (GND) gekoppelt ist, wobei die Vorladeschaltung (34) aktivierbar (PRE) ist, in Reaktion darauf, dass die Ausgangsspannung (Vout) von der ersten Eingangsspannung (Vin1) auf die zweite Eingangsspannung (Vin2) umgeschaltet wird.

5. Schalterschaltung (30) nach Anspruch 4, wobei die Vorladeschaltung (34) eine durch ein Vorladesignal (PRE) steuerbare Pull-Down-Vorrichtung (N3) sowie eine mit der Pull-Down-Vorrichtung in Reihe geschaltete Kaskadenvorrichtung (36) umfasst.

6. Schalterschaltung (30) nach einem der vorhergehenden Ansprüche, der eine Steuerschaltung (31) umfasst, die so konfiguriert ist, dass sie das erste (LV1a), das zweite (LV1b), das dritte (LV2a) und das vierte (LV2b) Niederspannungssteuersignal sowie die erhöhte Massespannung (e_GND) erzeugt,
wobei die Steuerschaltung (31) so konfiguriert ist, dass sie die Ausgangsspannung (Vout) von der ersten Eingangsspannung (Vin1) auf die zweite Eingangsspannung (Vin2) umschaltet, indem sie nacheinander die folgenden Schritte (i) bis (iii) ausführt:
(i) Ausschalten der ersten (P1a) und der zweiten (P1b) Durchgangsvorrichtung;
(ii) Einstellen der erhöhten Massespannung (e_GND) auf die Massespannung (GND); und
(iii) Einschalten der dritten (P2a) und der vierten (P2b) Durchgangsvorrichtung;
und wobei die Steuerschaltung (31) so konfiguriert ist, dass sie die Ausgangsspannung (Vout) von der zweiten Eingangsspannung (Vin2) auf die erste Eingangsspannung (Vin1) umschaltet, indem sie nacheinander die folgenden Schritte (iv) bis (vi) ausführt:
(iv) Ausschalten der dritten (P2a) und der vierten (P2b) Durchgangsvorrichtung;
(v) Einstellen der erhöhten Massespannung (e_GND) auf die verschobene Massespannung (s_GND); und
(vi) Einschalten der ersten (P1a) und der zweiten (P1b) Durchgangsvorrichtung.

7. Schalterschaltung (30) nach Anspruch 4 und 6, wobei die Steuerschaltung (31) ferner für Folgendes konfiguriert ist:
während Schritt (i), Aktivieren (PRE) der Vorladeschaltung (34), um die Ausgangsspannung (Vout) zu senken; und
während Schritt (iii), Deaktiveren (PRE) der Vorladeschaltung (34).

8. Schalterschaltung (30) nach einem der vorhergehenden Ansprüche, wobei die erste Eingangsspannung (Vin1) in dem Bereich von 4,5 V bis 5 V liegt und die zweite Eingangsspannung (Vin2) im Bereich von 2 V bis 2,5 V liegt.

9. Schalterschaltung (30) nach einem der vorhergehenden Ansprüche, wobei die erste (P1a), die zweite (P1b), die dritte (P2a) und die vierte (P2b) Durchgangsvorrichtung jeweilige p-Kanal-MOS-Transistoren enthalten.

10. Schalterschaltung (30) nach einem der vorhergehenden Ansprüche, wobei jede der ersten (321a), der zweiten (321b), der dritten (322a) und der vierten (322b) Erhöhungsschaltung Folgendes umfasst:
einen jeweiligen Eingangsknoten (402), der so konfiguriert ist, dass er das jeweilige Niederspannungssteuersignal (In) empfängt, und einen jeweiligen Ausgangsknoten (404), der so konfiguriert ist, dass er das jeweilige verschobene Steuersignal (Out) erzeugt;
eine Latch-Schaltung, die einen ersten verriegelten Wechselrichter (INV3) und einen zweiten verriegelten Wechselrichter (INV4) enthält, wobei der erste verriegelte Wechselrichter (INV3) einen Eingangsanschluss, der mit einem ersten Latch-Knoten (42) verbunden ist, und einen Ausgangsanschluss aufweist, der mit einem zweiten Latch-Knoten (40) verbunden ist, und der zweite verriegelte Wechselrichter (INV4) einen Eingangsanschluss, der mit dem zweiten Latch-Knoten (40) verbunden ist, und einen Ausgangsanschluss aufweist, der mit dem ersten Latch-Knoten (42) verbunden ist;
einen weiteren Wechselrichter (44), der zwischen dem jeweiligen Eingangsknoten (402) und einem jeweiligen weiteren Knoten (46) gekoppelt ist und so konfiguriert ist, dass er an dem weiteren Knoten (46) das Komplementsignal (In) des jeweiligen Niederspannungssteuersignals (In) erzeugt;
einen ersten Transistor (N4), der einen Source-Anschluss, der mit dem jeweiligen Eingangsknoten (402) gekoppelt ist, um das jeweilige Niederspannungssteuersignal (In) zu empfangen, und einen Drain-Anschluss umfasst, der mit dem zweiten Latch-Knoten (40) gekoppelt (P4) ist; und
einen zweiten Transistor (N5), der einen Source-Anschluss, der
mit dem jeweiligen weiteren Knoten (46) gekoppelt ist, um das Komplementsignal (In) des jeweiligen Niederspannungssteuersignals (In) zu empfangen, und einen Drain-Anschluss (P5) aufweist, der mit dem ersten Latch-Knoten (42) gekoppelt ist;
wobei der zweite Latch-Knoten (40) mit dem jeweiligen Ausgangsknoten (404) gekoppelt (B3) ist.

11. Schalterschaltung (30) nach Anspruch 10, wobei jede der ersten (321a), der zweiten (321b), der dritten (322a) und der vierten (322b) Erhöhungsschaltung Folgendes umfasst:
einen dritten Transistor (P4), der einen leitfähigen Kanal aufweist, der zwischen dem Drain-Anschluss des ersten Transistors (N4) und dem zweiten Latch-Knoten (40) angeordnet ist; und
einen vierten Transistor (P5), der einen leitfähigen Kanal aufweist, der zwischen dem Drain-Anschluss des zweiten Transistors (N5) und dem ersten Latch-Knoten (42) angeordnet ist.

12. Verfahren zum Betreiben einer Schalterschaltung (30) nach einem der vorhergehenden Ansprüche, wobei das Verfahren Folgendes umfasst:
Empfangen einer ersten Eingangsspannung (Vin1) an dem ersten Eingangsknoten (301);
Empfangen einer zweiten Eingangsspannung (Vin2), die niedriger ist als die erste Eingangsspannung (Vin1) am zweiten Eingangsknoten (302);
Umschalten des Ausgangsknotens (304) zwischen der ersten Eingangsspannung (Vin1) und der zweiten Eingangsspannung (Vin2), um die Ausgangsspannung (Vout) zu erzeugen;
Empfangen eines ersten Niederspannungssteuersignals (LV1a) an der ersten Erhöhungsschaltung (321a) und Erzeugen eines entsprechenden ersten verschobenen Steuersignals (HV1a);
Vorspannen der ersten Erhöhungsschaltung (321a) zwischen der ersten Eingangsspannung (Vin1) und einer verschobenen Massespannung (s_GND);
Empfangen eines zweiten Niederspannungssteuersignals (LV1b) an der zweiten Erhöhungsschaltung (321b) und Erzeugen eines entsprechenden zweiten verschobenen Steuersignals (HV1b);
Vorspannen der zweiten Erhöhungsschaltung (321b) zwischen der Ausgangsspannung (Vout) und einer erhöhten Massespannung (e_GND);
Empfangen eines dritten Niederspannungssteuersignals (LV2a) an der dritten Erhöhungsschaltung (322a) und Erzeugen eines entsprechenden dritten verschobenen Steuersignals (HV2a);
Vorspannen der dritten Erhöhungsschaltung (322a) zwischen der zweiten Eingangsspannung (Vin2) und einer Massespannung (GND);
Empfangen eines vierten Niederspannungssteuersignals (LV2b) an der vierten Erhöhungsschaltung (322b) und Erzeugen eines entsprechenden vierten verschobenen Steuersignals (HV2b) ;
Vorspannen der vierten Erhöhungsschaltung (322b) zwischen der Ausgangsspannung (Vout) und der erhöhten Massespannung (e_GND).

## Revendications

1. Circuit de commutation (30), comprenant :
un premier nœud d'entrée (301) configuré pour recevoir une première tension d'entrée (Vin1), un second nœud d'entrée (302) configuré pour recevoir une seconde tension d'entrée (Vin2) inférieure à la première tension d'entrée (Vin1), et un nœud de sortie (304) configuré pour produire une tension de sortie (Vout) commutable entre ladite première tension d'entrée (Vin1) et ladite seconde tension d'entrée (Vin2) ;
un premier dispositif de passage (P1a) et un deuxième dispositif de passage (P1b) disposés en série entre ledit premier nœud d'entrée (301) et ledit nœud de sortie (304) ;
un troisième dispositif de passage (P2a) et un quatrième dispositif de passage (P2b) agencés en série entre ledit second nœud d'entrée (302) et ledit nœud de sortie (304) ;
un premier circuit élévateur (321a) configuré pour recevoir un premier signal de commande basse tension (LV1a) et produire un premier signal de commande décalé (HV1a) correspondant pour commander ledit premier dispositif de passage (P1a), dans lequel le premier circuit élévateur (321a) est polarisé entre ladite première tension d'entrée (Vin1) et une tension de masse décalée (s_GND) ;
un deuxième circuit élévateur (321b) configuré pour recevoir un deuxième signal de commande basse tension (LV1b) et produire un deuxième signal de commande décalé (HV1b) correspondant pour commander ledit deuxième dispositif de passage (P1b), dans lequel le deuxième circuit élévateur (321b) est polarisé entre ladite tension de sortie (Vout) et une tension de masse élevée (e_GND) ;
un troisième circuit élévateur (322a) configuré pour recevoir un troisième signal de commande basse tension (LV2a) et produire un signal de commande décalé correspondant (HV2a) afin de commander ledit dispositif de passage (P2a), dans lequel le troisième circuit élévateur (322a) est polarisé entre la seconde tension d'entrée (Vin2) et une tension de masse (GND) ;
un quatrième circuit élévateur (322b) configuré pour recevoir un quatrième signal de commande basse tension (LV2b) et produire un quatrième signal de commande décalé (HV2b) correspondant pour commander ledit quatrième dispositif de passage (P2b), dans lequel le quatrième circuit élévateur (322b) est polarisé entre ladite tension de sortie (Vout) et ladite tension de masse élevée (e_GND).

2. Circuit de commutation (30) selon la revendication 1, dans lequel ladite tension de masse décalée (s_GND) est une tension fixe et une différence entre ladite première tension d'entrée (Vin1) et la tension de masse décalée (s_GND) est dans la plage de 2 V à 2,5 V.

3. Circuit de commutation (30) selon la revendication 1 ou la revendication 2, dans lequel ladite tension de masse élevée (s_GND) est une tension variable commutable entre ladite tension de masse décalée (s_GND) et ladite tension de masse (GND), et dans lequel ladite tension de masse élevée (s_GND) est commutée sur :
ladite tension de masse décalée (s_GND), en réponse à ladite tension de sortie (Vout) étant commutée sur la première tension d'entrée (Vin1) ; et
ladite tension de masse (GND), en réponse à ladite tension de sortie (Vout) étant commutée sur la seconde tension d'entrée (Vin2).

4. Circuit de commutation (30) selon l'une quelconque des revendications précédentes, comprenant un circuit de précharge (34) couplé entre ledit nœud de sortie (304) et la masse (GND), le circuit de précharge (34) étant activable (PRE) en réponse à ladite tension de sortie (Vout) étant commutée de la première tension d'entrée (Vin1) à la seconde tension d'entrée (Vin2).

5. Circuit de commutation (30) selon la revendication 4, dans lequel ledit circuit de précharge (34) comprend un dispositif d'abaissement (N3) pouvant être commandé par un signal de précharge (PRE), et un dispositif cascode (36) couplé en série au dispositif d'abaissement.

6. Circuit de commutation (30) selon l'une quelconque des revendications précédentes, comprenant un circuit de commande (31) configuré pour produire lesdits premier (LV1a), deuxième (LV1b), troisième (LV2a) et quatrième (LV2b) signaux de commande basse tension et ladite tension de masse élevée (e_GND),
dans lequel le circuit de commande (31) est configuré pour commuter ladite tension de sortie (Vout) de ladite première tension d'entrée (Vin1) à ladite seconde tension d'entrée (Vin2) en réalisant séquentiellement les étapes (i) à (iii) suivantes :
(i) la désactivation desdits premier (P1a) et deuxième (P1b) dispositifs de passage ;
(ii) le réglage de ladite tension de masse élevée (e_GND) sur la tension de masse (GND) ; et
(iii) l'activation desdits troisième (P2a) et quatrième (P2b) dispositifs de passage ;
et dans lequel le circuit de commande (31) est configuré pour commuter ladite tension de sortie (Vout) de ladite seconde tension d'entrée (Vin2) à ladite première tension d'entrée (Vin1) en réalisant séquentiellement les étapes (iv) à (vi) suivantes :
(iv) la désactivation desdits troisième (P2a) et quatrième (P2b) dispositifs de passage ;
(v) le réglage de ladite tension de masse élevée (e_GND) sur ladite tension de masse décalée (s_GND) ; et
(vi) l'activation desdits premier (P1a) et deuxième (P1b) dispositifs de passage.

7. Circuit de commutation (30) selon les revendications 4 et 6, dans lequel le circuit de commande (31) est en outre configuré pour :
pendant l'étape (i), activer (PRE) ledit circuit de précharge (34) pour abaisser ladite tension de sortie (Vout) ; et
lors de l'étape (iii), désactiver (PRE) ledit circuit de précharge (34).

8. Circuit de commutation (30) selon l'une quelconque des revendications précédentes, dans lequel ladite première tension d'entrée (Vin1) est dans la plage de 4,5 V à 5 V et ladite seconde tension d'entrée (Vin2) est dans la plage de 2 V à 2,5 V.

9. Circuit de commutation (30) selon l'une quelconque des revendications précédentes, dans lequel lesdits premier (P1a), deuxième (P1b), troisième (P2a) et quatrième (P2b) dispositifs de passage comportent des transistors MOS à canal p respectifs.

10. Circuit de commutation (30) selon l'une quelconque des revendications précédentes, dans lequel chacun desdits premier (321a), deuxième (321b), troisième (322a) et quatrième (322b) circuits élévateurs comprend :
un nœud d'entrée (402) respectif configuré pour recevoir un signal de commande basse tension (In) respectif et un nœud de sortie (404) respectif configuré pour produire un signal de commande décalé (Out) respectif ;
un circuit de verrouillage comportant un premier onduleur verrouillé (INV3) et un second onduleur verrouillé (INV4),
le premier onduleur verrouillé (INV3) ayant une borne d'entrée connectée à un premier nœud de verrouillage (42) et une borne de sortie connectée à un second nœud de verrouillage (40), et le second onduleur verrouillé (INV4) ayant une borne d'entrée connectée au second nœud de verrouillage (40) et une borne de sortie connectée au premier nœud de verrouillage (42) ;
un autre onduleur (44) couplé entre ledit nœud d'entrée (402) respectif et un autre nœud (46) respectif et configuré pour produire, au niveau dudit autre nœud (46),
le signal de complément (In) du signal de commande basse tension respectif (In) ;
un premier transistor (N4) ayant une borne source couplée audit nœud d'entrée (402) respectif pour recevoir le signal de commande basse tension (In) respectif et une borne de vidange couplée (P4) audit second nœud de verrouillage (40) ; et
un deuxième transistor (N5) ayant une borne source
couplé audit autre nœud (46) respectif pour recevoir le signal de complément (In)du signal de commande basse tension (In) respectif et une borne de drain couplée (P5) audit premier nœud de verrouillage (42) ;
dans lequel ledit second nœud de verrouillage (40) est couplé (B3) au nœud de sortie (404) correspondant.

11. Circuit de commutation (30) selon la revendication 10, dans lequel chacun desdits premier (321a), deuxième (321b), troisième (322a) et quatrième (322b) circuits élévateurs comprend :
un troisième transistor (P4) ayant un canal conducteur disposé entre la borne de drain dudit premier transistor (N4) et ledit second nœud de verrouillage (40) ; et
un quatrième transistor (P5) ayant un canal conducteur disposé entre la borne de drain dudit deuxième transistor (N5) et ledit premier nœud de verrouillage (42).

12. Procédé de fonctionnement d'un circuit de commutation (30) selon l'une quelconque des revendications précédentes, le procédé comprenant :
la réception d'une première tension d'entrée (Vin1) au niveau dudit premier nœud d'entrée (301) ;
la réception d'une seconde tension d'entrée (Vin2) inférieure à la première tension d'entrée (Vin1) au niveau dudit second nœud d'entrée (3 02) ;
la commutation dudit nœud de sortie (304) entre ladite première tension d'entrée (Vin1) et ladite seconde tension d'entrée (Vin2) afin de produire ladite tension de sortie (Vout) ;
la réception d'un premier signal de commande basse tension (LV1a) au niveau dudit premier circuit élévateur (321a) et la production d'un premier signal de commande décalé (HV1a) correspondant ;
la polarisation dudit premier circuit élévateur (321a) entre ladite première tension d'entrée (Vin1) et une tension de masse décalée (s_GND) ;
la réception d'un deuxième signal de commande basse tension (LV1b) au niveau dudit deuxième circuit élévateur (321b) et la production d'un deuxième signal de commande décalé (HV1b) correspondant ;
la polarisation dudit deuxième circuit élévateur (321b) entre ladite tension de sortie (Vout) et une tension de masse élevée (e_GND) ;
la réception d'un troisième signal de commande basse tension (LV2a) au niveau dudit troisième circuit élévateur (322a) et la production d'un troisième signal de commande décalé (HV2a) correspondant ;
la polarisation dudit troisième circuit élévateur (322a) entre ladite seconde tension d'entrée (Vin2) et une tension de masse (GND) ;
la réception d'un quatrième signal de commande basse tension (LV2b) au niveau dudit quatrième circuit élévateur (322b) et la production d'un quatrième signal de commande décalé (HV2b) correspondant ;
la polarisation dudit quatrième circuit élévateur (322b) entre ladite tension de sortie (Vout) et ladite tension de masse élevée (e_GND).
